# EUROPEAN PATENT APPLICATION

(11) **EP 4 431 449 A1**
(43) Date of publication of application: **18.09.2024**
(21) Application number: 23162600.3
(22) Date of filing: 17.03.2023
(51) Int. Cl.: B81B 7/00, B81C 1/00

(54) **SEMICONDUCTOR DIE AND METHOD FOR ATTACHING A SEMICONDUCTOR DIE TO A SOLID STRUCTURE WITH CONTROLLED FILLET HEIGHT**

(71) Applicant: TE Connectivity Solutions GmbH, 8200 Schaffhausen (CH)
(72) Inventor: JENNI, Kaspar, 8200 Schaffhausen (CH); BRUNNER, Ismael, 8200 Schaffhausen (CH); ARNOLD, Thomas, 8200 Schaffhausen (CH)
(74) Representative: Grünecker Patent- und Rechtsanwälte PartG mbB

(57) **Abstract**

The invention relates to a semiconductor die (1), in particular for a MEMS-sensor device (3), the semiconductor die (1) having a top side (15), a bottom side (17) opposite to the top side (15), and at least one side surface (19) connecting the top side (15) and the bottom side (17), wherein the bottom side (17) and at least parts of the at least one side surface (17) are configured to be attached to a solid structure (5) via a die attach material (7). In order to define the fillet height (33) of a fillet (30) forming by the die attach material (7) on the side surface, at least the side surface (19) comprises at least one attachment control element (37) that is configured to define at least one attachment zone (39) of the side surface (19) to be contacted by the die attach material (7) and/or at least one exclusion zone (45) configured to not to be contacted by the die attach material (7).

## Description

The invention relates to a semiconductor die, in particular for a microelectromechanical system (MEMS) such as a MEMS-sensor device, the semiconductor die having a top side, a bottom side opposite to the top side and at least one side surface connecting the top and bottom side, wherein the bottom side and at least parts of the at least one side surface are configured to be attached to a solid structure via a die attach material. The invention further relates to a method for attaching a semiconductor die to a solid structure, in particular to a substrate, a package or a lead frame.

Semiconductor dies may contain integrated circuits, sensor elements or other components. A semiconductor die is usually separated from a wafer by a process called dicing. Subsequently, a semiconductor die may be fixated to a solid structure, such as a substrate, a package or a lead frame.

For fixating the semiconductor die to the solid structure, a die attach material is used. Die attach material may be a glue, in particular a glue comprising epoxy, silicone or other materials. Furthermore, the die attach material may comprise particles, for example particles configured to increase heat conductivity between the semiconductor die and the solid structure.

When a semiconductor die is attached to a solid structure and die attach material is applied between the semiconductor die and the solid structure, the die attach material may form a fillet at the side surface of the semiconductor die. The height of said fillet may define to what extend the side or sides of the semiconductor die are fixated to the solid structure. A large fillet height may improve the fixation of the semiconductor die to the solid structure, but also increases mechanical stress on the semiconductor die. If, for example, the solid structure is under mechanical stress due to CTE (coefficient of thermal expansion) mismatch, this mechanical stress may be carried into the semiconductor die via the die attach material (when the die attach material is in a solid state). A low fillet height may reduce mechanical stress carried from the solid structure into the semiconductor die, but may provide insufficient mechanical stability of the fixation of the semiconductor die to the solid structure.

It is thus the object of the invention to provide a semiconductor die and a method for attaching a semiconductor die to a solid structure, which allows for control of the fillet height when the semiconductor die is attached to a solid structure.

For the semiconductor die mentioned above, this object is achieved in that at least the side surface comprises at least one attachment control element that is configured to define at least one attachment zone of the side surface to be contacted by the die attach material and/or at least one exclusion zone configured not to be contacted by the die attach material.

The method for attaching a semiconductor die to a solid structure solves the object in that the method comprises the steps of:
- providing a wafer made from at least one semiconducting material;
- forming at least one attachment control element for at least one die, in particular at least one die to be separated from the wafer;
- separating the wafer into separate semiconductor dies;
- attaching at least one of the semiconductor dies comprising at least one attachment control element to a solid structure using a die attach material.

The method steps of forming at least one attachment control element and separating the wafer into separate semiconductor dies may be performed in any order.

Due to the at least one attachment control element, it is possible to define areas in which the semiconductor die may be contacted by the die attach material and/or in which contact by the die attach material can be avoided. Thereby, a fillet height for the semiconductor die can be defined. It is thus possible to adapt the fillet to the application of the semiconductor die and to the properties of the semiconductor die, the die attach material and/or the solid structure.

The semiconductor die may be a semiconductor die for a MEMS sensor device, preferably for a pressure sensor, a force sensor or an accelerometer. Thus, the semiconductor die may be provided with a membrane, in particular a membrane containing or supporting piezoresistive elements, a piezoelectric membrane or a membrane forming a capacitive element

In the following, further improvements of the invention will be described. The additional improvements may be combined independently of each other, depending on whether a particular advantage of a particular improvement is needed in a specific application.

The improvements described with respect to the semiconductor die and their advantages also relate to the method according to the invention. Likewise, the improvements and the advantages mentioned with respect to the method also apply to the semiconductor die according to the invention. The method according to the invention is used preferably for producing semiconductor dies according to the invention.

The invention further relates to a MEMS-sensor device, the device comprising at least one semiconductor die according to the invention or at least one semiconductor die that is produced by the method according to the invention, wherein the semiconductor die further comprises at least one membrane and is attached to a solid substrate by a die attach material, the die attach material extending at least in regions between the semiconductor die and the substrate.

In the following, the terms top and bottom are used. The bottom side refers to the side of the semiconductor die with which it may be fixated to the solid structure. The term top side refers to the opposite side of the semiconductor die.

According to a first advantageous improvement of the semiconductor die, the at least one die attach control element may be a stop element for defining a maximum height for the die attach material, in particular along a vertical direction. Thereby, the maximum height of a fillet may be defined.

Preferably, the at least one stop element is a physical barrier between the at least one attachment zone and the at least one exclusion zone. The physical barrier may prevent die attach material from flowing into an area, in which die attach material is not wanted.

In order to form a simple stop element, the at least one stop element may be formed as a step between two vertical sections of the side surface. Preferably, the step introduces two sharp edges into the side surface. The sharp edges may form essentially right angles. To be sharp enough, the edges may have radii below 50 µm.

As an alternative to a stop element or in addition to a stop element, the at least one attachment control element may be formed as at least one region with increased or decreased wettability for the die attach material compared to a surface of the semiconductor die in an adjacent region.

In particular, at least one attachment zone of the side surface may comprise a region with an increased wettability for the die attach material. Likewise, at least one exclusion zone may be provided with a region having a decreased wettability for the die attach material.

For example, a region of the side surface that is closer to the bottom side may be provided with an increased wettability. Thus, the die attach material will have a high affinity to wet this area. Alternatively or additionally, a region that is further away from the bottom side may be provided with a decreased wettability.

Increased or decreased wettability may be reached by surface functionalization. In particular by controlling the surface energy. Thus, the at least one attachments control element may be formed as a functionalized surface in the at least one region. Surface functionalization may be achieved by coating the surface of the semiconductor die. For example, a coating may be applied to the surface that increases or decreases the wettability. Alternatively, the surface of the semiconductor die may be functionalized by structuring the surface. By way of example, the surface may be etched with an appropriate etching method. Thereby, an increased roughness or a microstructure may be formed into the surface.

According to another advantageous improvement of the semiconductor die, the bottom side of the semiconductor die may comprise a functionalized surface at least in parts. In particular, the bottom side may be provided with a functionalized surface in order to increase the wettability with die attach material. This may help in ensuring that the bottom side is wetted by the die attach material and a mechanically stable fixation of the semiconductor die to the solid structure may be achieved.

In order to define a thickness of die attach material between the bottom side of the die and the solid structure, the bottom side of the semiconductor die may be provided with at least one spacer for spacing a bottom surface of the semiconductor die apart from the solid structure. In other words, the at least one spacer may project from the bottom surface. The thickness of the die attach material between the bottom side of the semiconductor die and the solid structure is also known as bond line thickness (BLT).

The at least one spacer may be formed as a foot. Preferably, a semiconductor die provided with spacers comprises a plurality of spacers, for example four spacers in the case of an overall rectangular semiconductor die.

Also in case a spacer is present, the remaining bottom surface may be functionalized and thus configured to increase the wettability with die attach material.

The semiconductor die may comprise at least one membrane, in particular a membrane with piezoresistors formed monolithically with the remaining semiconductor die. Thus, the semiconductor die may be used as a piezoresistive sensor element, in particular for a pressure sensor, a force sensor or an accelerometer. The at least one membrane with piezoresistors is preferably arranged in a central region of the semiconductor die. The central region may be the center of a plane defined by top and bottom sides. The central region may be arranged radially in the center of the semiconductor die, in particular spaced apart horizontally from at least one attachment control element.

According to another advantageous improvement of the semiconductor die, the semiconductor die may have an overall Π-shaped cross-section comprising two legs and a web connecting the legs at a right angle, wherein the web forms the top side and the outer sides of the legs form the side surfaces of the semiconductor die. The shape of the semiconductor die is particularly advantageous in the case of a pressure sensor. In this case in particular, a membrane may be located in the region that forms the web in the Π-shaped cross-section.

The ends of the legs opposite to the topside may form bottom surfaces and may be provided with spacers. Preferably, the semiconductor die may have a Π-shaped cross section that extends continuously. Thus, the semiconductor die may have an overall cup shape, in particular a cup with a rectangular cross-section seen along a viewing axis extending perpendicular to the top side.

In the case of a semiconductor die whose shape comprises legs, the inner side of the legs may have inner side surfaces that can be provided with attach control elements as well. Thus, a fillet height on the inner side of the legs may be well defined. It may be avoided thereby that die attach material contacts the membrane.

The method according to the invention may be further improved in that a membrane with piezoresistive elements is formed into the semiconductor die before separating the wafer into separate dies. The membrane may be formed preferably by etching.

The at least one attach control element may be formed by at least one of the following methods: laser cutting, sawing, etching.

The surface of a bottom side or at least one side surface of at least one semiconductor die to be separated from the wafer may be functionalized by using at least one of the following methods: coating, etching, layer deposition.

By way of example, atomic layer deposition (ALD), physical vapor deposition (PVD), chemical vapor deposition (CVD), plasma enhanced chemical vapor deposition (PECVD) or other methods may be used for the deposition of layers.

Etching for shaping the attached control element, for functionalizing the surface, for forming a membrane and/or for shaping the semiconductor die may be done by at least one of the following methods: reactive ion etching (RIE) and deep reactive ion etching (DRIE). Other methods for layer deposition or etching may be applied depending on the specific application.

Preferably, the same method is used for separating the wafer into separate semiconductor dies and for forming the at least one attachment control element. This may reduce production costs.

Separating the wafer into separate semiconductor dies may be performed by typical dicing methods such as laser cutting, sawing, etching or scribing and snapping.

In the following, the invention and its improvements are described in greater detail using exemplary embodiments and with reference to the drawings. As described above, the various features shown in the embodiments may be used independently of each other in specific applications.

In the following figures, elements having the same function and/or the same structure will be referenced by the same reference signs.

In the drawings:
- Fig. 1: shows a simple sketch in a cross-sectional view of a semiconductor die on a solid structure without an attachment control element for explanatory reasons;
- Fig. 2: shows a first embodiment of a semiconductor die with an attachment control element formed as a step in a cross-sectional view;
- Fig. 3: shows a second embodiment of a semiconductor die with attachment control elements formed as steps in a cross-sectional view;
- Fig. 4: shows a third embodiment of a semiconductor die with attachment control elements formed as steps in a cross-sectional view;
- Fig. 5: shows an embodiment of a semiconductor die with a functionalized surface in a cross-sectional view;
- Fig. 6: shows another embodiment of a semiconductor die with a functionalized surface in a cross-sectional view;
- Fig. 7: shows an embodiment of a semiconductor die with a functionalized surface in combination with attachment control elements formed as steps in a cross-sectional view;
- Fig. 8: shows another embodiment of a semiconductor die with a functionalized surface in combination with attachment control elements formed as steps in a cross-sectional view; and
- Fig. 9: shows an embodiment of a semiconductor die with spacers in a cross-sectional view.

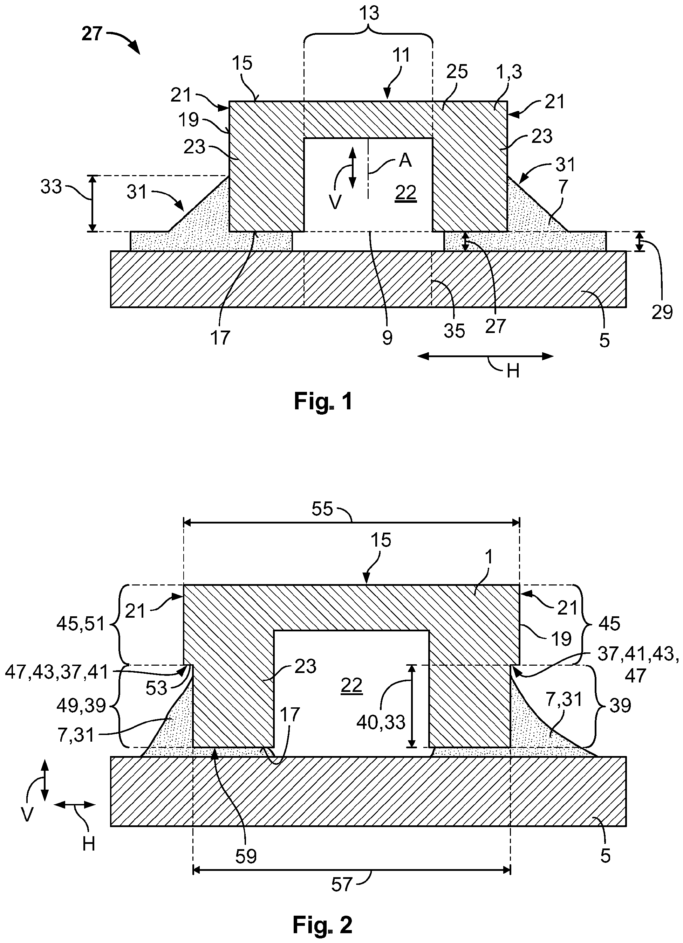

In the following, reference is made to Fig. 1. Fig. 1 only serves for explanatory reasons.

Fig. 1 shows a semiconductor die 1 attached to a solid structure 5 via a die attach material 7 in a cross-sectional view. The solid structure 5 may be a substrate, a package, or any other suitable solid structure configured to carry the semiconductor die.

The semiconductor die may have an overall rectangular cubic shape 9, which is indicated by the dashed line in Fig. 1. This may be the case particularly when the semiconductor die comprises integrated circuits or other electronic structures.

However, the semiconductor die 1 according to the invention, which will be described later on with respect to Figs. 2 to 9, is preferably a micro-electromechanical system (MEMS), in particular a MEMS sensor device 3 and is thus provided with a membrane 11 in a central region 13 of the semiconductor die 1.

The semiconductor die 1 has a top side 15 and a bottom side 17 opposite to the top side 15. The top side 15 and the bottom side 17 are connected via a side surface 19, which preferably extends continuously around the semiconductor die 1, preferably around a central axis A of the semiconductor die 1.

The semiconductor die 1 may have four planar sides 21, in particular in case of a rectangular cubic shape 9. However, as the sides 21 are interconnected with each other, they have a common continuous side surface 19.

The semiconductor die 1 may have an overall Π-shaped cross-section. Thus, the semiconductor die 1 may have an overall cup shape having a recess 22 that extends into the bottom side 17.

The Π-shaped cross-section of the semiconductor die 1 may be formed by two legs 23, which are spaced apart from each other along a horizontal direction H and which extend parallel to each other and with a vertical direction V.

The two legs 23 are interconnected by a web 25 that extends parallel to the horizontal direction H and perpendicular to the legs 23. The membrane 11 may form or be part of the web 25. Between the web 25 and the legs 23, the recess 22 is located.

The terms "leg" and "web" refer to the cross-section only. In particular, in an overall cup shape semiconductor die, the legs 23 in the cross-section may be formed by walls that form the sides 21, while the web 25 may be formed by a top plate or by the membrane 11.

The semiconductor die 1 is fixated on the solid structure 5 by the die attach material 7. Preferably, in order to assemble the arrangement comprising the solid structure 5 and the semiconductor die 1, the die attach material 7 is applied in the liquid phase onto the solid structure 5. Subsequently, the semiconductor die 1 is placed on the die attach material 7.

By applying a predefined pressure onto the semiconductor die 1, the distance 27 between the semiconductor die 1 and the solid structure 5 can be defined during the arrangement of the semiconductor die 1 on the solid structure 5. This distance 27 corresponds to the thickness 29 of the layer of die attach material 7 between the semiconductor die 1 and the solid structure 5. This thickness 29 is also known as "bond line thickness" (BLT).

In the liquid phase of the die attach material 7, the die attach material 7 tends to climb up the side surfaces 19 of the semiconductor die 1 and wets the side surface 19. Thereby, a fillet 31 is formed around the semiconductor die 1. Depending on the surface energy and of the properties of the die attach material 7, the fillet 31 extends up to a certain height, the fillet height 33.

The fillet height 33 is important for the semiconductor die 1. The semiconductor die 1 needs to be securely fixated to the solid structure 5. Thus, the fillet height 33 should not be too low. On the other side, the higher the fillet height 33, the more mechanical stress may be introduced from the solid structure 5 into the semiconductor die 1.

In particular, in case of a semiconductor die 1 having a membrane 11, this may lead to erroneous measurements as the mechanical stress induced via the die attach material 7 into the semiconductor die 1 may be interpreted as pressure on the membrane containing piezoresistive elements 11.

Particularly in case of a semiconductor die 1 for a MEMS sensor device 3, the solid structure 5 may have a through hole 35, which is indicated by dashed lines in Fig. 1. This through hole 35 may open a channel to the bottom side 17, in particular into the recess 22. Thus, a fluid communication between an outside medium and the membrane 11 may be achieved.

An object of the invention is to control the fillet height 33. In the following, different embodiments of a semiconductor die 1 according to the invention are described with respect to Figs. 2 to 9. For the sake of brevity, only the differences with respect to the semiconductor die 1 described with respect to Fig. 1 are mentioned.

Die attachment material 7 between the bottom surface 59 and the solid structure 5 may preferably extend continuously along the circumference of the semiconductor die 1 along the horizontal direction H. Thereby, the recess 22 or the volume defined by the recess 22 may be sealed to the outside.

A first advantageous embodiment of a semiconductor die 1 according to the invention is described with respect to Fig. 2. In the side surfaces 19 of the semiconductor die 1, an attachment control element 37 is formed.

The attachment control element 37 may extend circumferentially around the semiconductor die 1. Alternatively, each side 21 may be provided with an attachment control element 37. Preferably, the attachment control element 37 extends around the semiconductor die 1 parallel to the horizontal direction H.

The attachment control element 37 defines where die attach material 7 wets the side surfaces 19. In particular, the attachment control element 37 defines an attachment zone 39 of the side surfaces 19 that is to be contacted by the attach material 7.

The attachment zone 39 extends around the semiconductor die 1 along its circumference parallel to the horizontal direction H.

In the vertical direction V, the attachment control element 37 defines the border of the attachment zone 39. Thereby, a maximum height 40 is defined. If the die attach material 7 spreads up to this maximum height 40, the maximum height 40 may be identical to the fillet height 33.

The attachment control element 37 is a stop element 41 for the die attach material 7. Thus, the attachment control element 37 may prevent the die attach material 7 form further spreading in the vertical direction V on the side surface 19.

In particular, the attachment control element 37 forms a physical barrier 43. The attachment control element 37 does not only define an attachment zone 39, but also an exclusion zone 45 that is not to be contacted by the die attach material 7. As the attachment control element 37 acts as a stop element for the die attach material 7 along the vertical direction V, it excludes the die attach material 7 form spreading into the exclusion zone 45.

The attachment control element 37 is preferably formed as a step 47. The step 47 extends between two vertical sections 49 and 51 of the side surfaces 19. The first vertical section 49 is closer to the bottom side 17 and may be identical to the attachment zone 39.

A second vertical section 51 extends along the vertical direction V from the attachment control element 37 to the top side 15 and may be identical to the exclusion zone 45.

The step 47 comprises a horizontal section 53, which extends parallel to the horizontal direction H. From the first vertical section 49, the horizontal section 53 of the step 47 extends outwardly and perpendicular to the vertical section 49.

The horizontal section 53 is followed by the vertical section 51, which extends perpendicular to the horizontal section 53. Thereby, the semiconductor die 1 may have a larger diameter 55 in the region of vertical section 51 compared to the diameter 57 in the region of vertical section 49. In other words, the semiconductor die 1 may have an overall mushroom shape.

Preferably, the die attach material 7 is in contact with the semiconductor die 1 in the attachment zone 39 or, if present, in the attachment zone 39, and at the bottom surface 59. The bottom surface 59 may be located at the free ends of the legs 23.

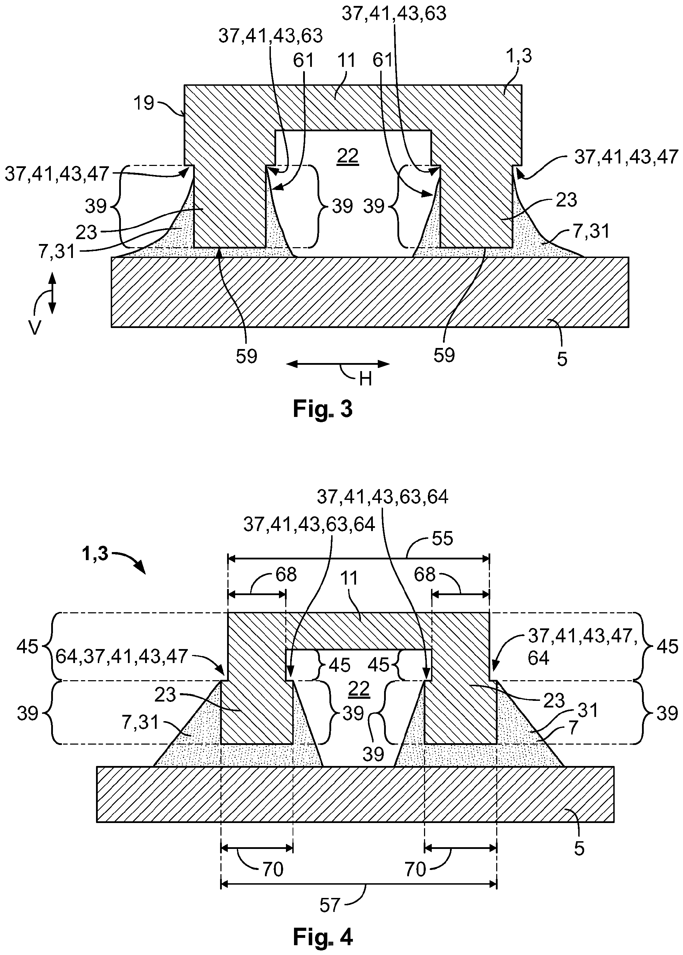

In the following, a second advantageous embodiment of the semiconductor die 1 is described with respect to Fig. 3. Again, only the differences to the semiconductor die 1 described with respect to Fig. 1 and to the first embodiment of the invention described with respect to Fig. 2 are mentioned.

In addition to the step 47, which may be similar to the one described with respect to Fig. 2, the inner sides 61 of the legs 23 are also provided with inner steps 63 that act as physical barriers 43 and thus form attachment control elements 37 configured as stop elements 41.

By way of example, the inner steps 63 are shown mirror-symmetrically to the steps 47 and on the same height as these along the vertical direction V. However, this is not mandatory. The inner steps 63 may be located at a different position along the vertical direction V and may also differ in size from the steps 47 on the side surfaces 19.

The inner steps 63 may define additional attachment zones 39. The inner steps 63 may be advantageous in order to prevent die attachment material from reaching the membrane 11.

In the embodiment shown in Fig. 3, die attach material 7 contacts the semiconductor die 1 in the attachment zones 39 on the side surfaces 19, the bottom surfaces 59 and the attachment zones 39 on the inner sides 61 of the legs 23. This may improve the fixation of the semiconductor die 1 to the solid structure 5.

Reference is now made to Fig. 4, in which a further advantageous embodiment of a semiconductor die 1 according to the invention is shown.

As an alternative to the shape of the semiconductor die 1 described above with respect to Figs. 2 and 3, the steps 47 and 63 have inverse shapes. In other words, the diameter 55 is smaller than the diameter 57. Further, each leg 23 has a diameter 70 in the region of the attachment zone 39 that is bigger than a diameter 68 in the region of the exclusion zone 45.

The step 47 and 63 thus form terrace-like structures 64. These structures 64 may hinder die attach material 7 to spread further upwards along the vertical direction V.

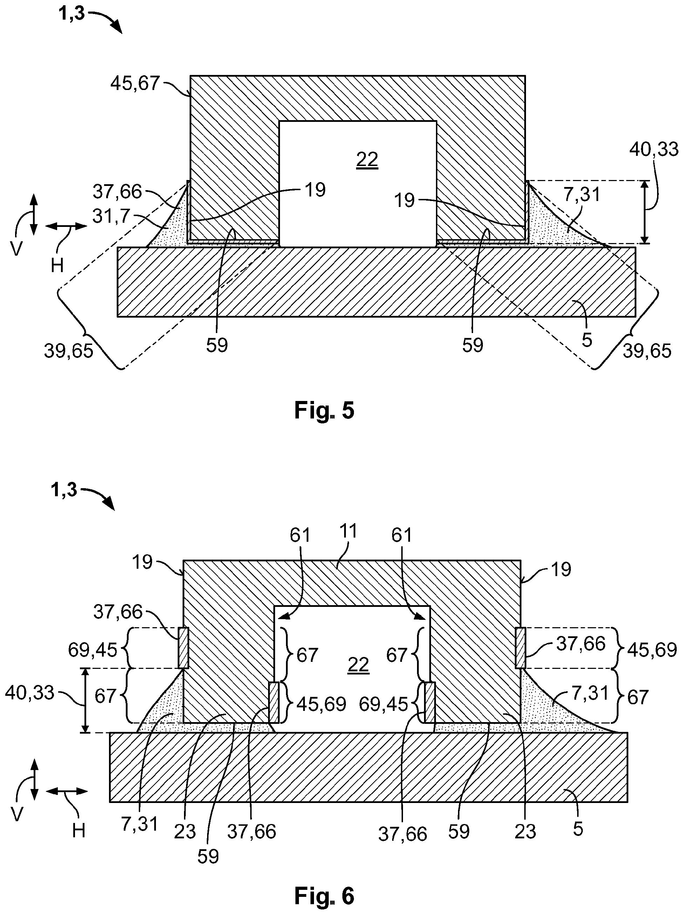

In contrast to the embodiments of the semiconductor die 1, described with respect to Figs. 2 to 4, the semiconductor die 1 of Fig. 5 does not comprise an attachment control element 37 that is formed as a physical barrier 43, but as a region 65 having increased wettability for the die attach material 7.

In the region 65, wettability of the side surface 19 and bottom surfaces 59 is increased compared to an adjacent region 67 of the side surface 19. The region 65 may comprise a functionalized surface 66. Surface functionalization to form the functionalized surface 66 may be achieved by typical methods such as coating, etching, layer deposition or others.

In the region 65, the side surface 19 and bottom surface 59 may have an increased surface energy.

Preferably, the die attach material 7 only contacts the semiconductor die 1 in the region 65. The region 65 may form the attachment zone 39. The region 67 of the side surface 19 may thus form the exclusion zone 45.

The region 65 may define a maximum height 40 up to which the die attach material 7 may contact the semiconductor die 1 in the vertical direction V. Thereby, the fillet height 33 may be defined.

Fig. 6 shows another embodiment of the semiconductor die 1 according to the invention, which utilizes surface functionalization for forming attachment control elements 37.

In contrast to the embodiment described with respect to Fig. 5, the embodiment shown in Fig. 6 comprises attachment control elements 37 formed as functionalized surfaces 66 in regions 69 configured to reduce the wettability for the die attach material 7.

In the regions 69, the surface of the semiconductor die 1 may have a reduced surface energy compared to adjacent surface regions 67. Here too, the surface functionalization may be achieved by typical methods as mentioned above.

The regions 69 form exclusion zones 45 that may hinder the die attach material 7 from contacting these regions 69.

Preferably, the semiconductor die 1 has one attachment control element 37 on the inner side 61 of each leg 23 and one on the outer side. The attachment control element 37 on the inner side 61 is preferably arranged close to the bottom surface 59 and may thus prevent die attach material 7 from contacting the inner sides 67 of the leg 23. Thereby, a membrane 11 may be protected from die attach material 7.

On the side surface 19, the other attachment control element 37 may be a region 69 arranged in a height defining the maximum height 40 and thereby the fillet height 33. Starting from this maximum height 40, the region 69 may extend upwardly along the vertical direction V in order to form the exclusion zone 45.

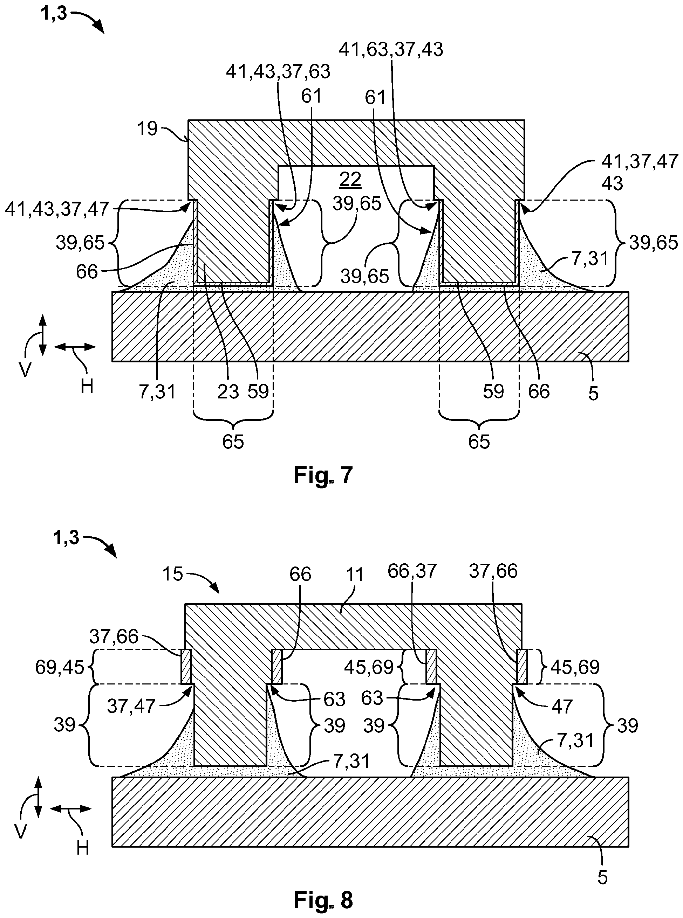

Reference is now made to Fig. 7. The semiconductor die 1 shown in Fig. 7 may have a similar shape in the cross-section to the embodiment described above regarding Fig 3.

Thus, the legs 23 may each have a step 47 in the side surface 19 and, additionally, an inner step 63 on the inner side 61.

In addition to steps 47 and 63, which may act as physical barriers 43 for the die attach material 7, the embodiment shown in Fig. 6 is further provided with functionalized surfaces 66.

The functionalized surfaces 66 extend on the bottom surfaces and from there on upwardly along the vertical direction V up to the step 37 on the side surface 19 and to the inner steps 63 on the inner side 61.

Thus, in the cross-sectional view, the functionalized surface 66 on each leg 23 may have an overall U-shape. Thus, the functionalized surface 66 forms a region 65 in the already existing attachment zone 39 formed by the steps 37 and 63. Thereby, the wettability for die attach material 7 in the attachment zone 39 may be further improved.

The functionalized surface 66 may be similar to the functionalized surface 66 described with respect to Fig. 5. Thus, the embodiment shown in Fig. 7 may be regarded as a combination of the embodiments described above with respect to Figs 3 and 5.

Another advantageous embodiment of the semiconductor die 1 according to the invention is shown in Fig. 8.

This embodiment also utilizes the combination of embodiments described above. Here, the embodiments described with respect to Figs. 3 and 6 are combined.

A semiconductor die 1 comprising the overall shape as described with respect to Figs. 3 and 7 is further provided with functionalized surfaces 66. However, in contrast to the embodiment of Fig. 7 described above, the embodiment of Fig. 8 is provided with functionalized surfaces 66 according to the embodiment described with respect to Fig. 6, namely functionalized surfaces 66 that form regions 69 with a reduced wettability for the die attach material 7. Thus, the functionalized surfaces 66 form exclusion zones 45.

The regions 69 are arranged along the vertical direction V upwardly starting from the steps 47 and 63. Thus, the functionalized surfaces 66 may support the already existing attachment control elements 37 formed by steps 47 and 63 in preventing die attach material 7 form spreading upwardly towards the top side 15 of the semiconductor die 1 and in particular from reaching the membrane 11.

It is further possible to provide an embodiment (not shown), which combines the embodiments described with respect to Figs. 7 and 8 above. Thus, two differently functionalized surfaces may be provided: first, functionalized surfaces 66 below the steps 37, 47 and 63 to form regions 69 with improved wettability for die attach material 7 and, second, functionalized surfaces 66 above the steps 47 and 63 to form regions 69 with reduced wettability.

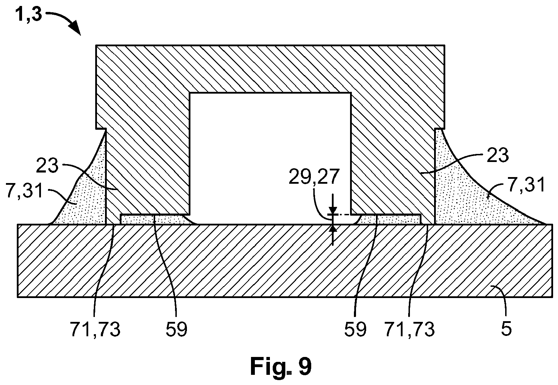

Finally, a further advantageous embodiment of the semiconductor die 1 is described with respect to Fig. 9.

By way of example, the overall cross-sectional shape of the semiconductor die 1 resembles a semiconductor die 1 as described with respect to Fig. 2. However, this is not mandatory. The semiconductor die 1 may have any suitable shape.

The semiconductor die 1 is provided with spacers 71 on its bottom surface 59. The spacers 71 space the remaining bottom surface 59 apart from the solid structure 5. The term "remaining surfaces 59" refers to regions of the bottom surface 59 that do not comprise the spacers 71.

Due to the spacers 71, the distance 27 between the bottom surface 59 and the solid structure 5 may be defined. Hence, a well-defined thickness 29 of the die attach material 7 between the bottom surface 59 and the solid structure 5 may be achieved.

The spacers 71 may be shaped as separate feet 73 projecting downwardly from the legs 23.

In the alternative, one or more spacers 71 may be formed as a continuous rib extending along the circumference of the semiconductor die 1. However, in order to achieve even spreading of die attach material 7, the spacers 71 are preferably formed as separate feet 73.

The semiconductor die 1 shown in Fig. 9 may be provided with any of the attachment control elements 37 described above with respect to Figs. 2 to 8.

### REFERENCE NUMERALS

- 1: semiconductor die
- 3: MEMS-sensor device
- 5: solid structure
- 7: die attach material
- 9: rectangular cubic shape
- 11: membrane
- 13: central region
- 15: top side
- 17: bottom side
- 19: side surface
- 21: side
- 22: recess
- 23: legs
- 25: web
- 27: distance
- 29: thickness
- 31: fillet
- 33: fillet height
- 35: through hole
- 37: attachment control element
- 39: attachment zone
- 40: maximum height
- 41: stop element
- 43: physical barrier
- 45: exclusion zone
- 47: step
- 49, 51: vertical sections
- 53: horizontal section
- 55, 57: diameters
- 59: bottom surface
- 61: inner side
- 63: inner step
- 64: terrace-like structure
- 65: region with increased wettability
- 66: functionalized surface
- 67: adjacent region
- 68: diameter of leg in exclusion zone
- 69: region with decreased wettability
- 70: diameter of leg in attachment zone
- 71: spacer
- 73: foot
- A: central axis
- H: horizontal direction
- V: vertical direction

## Claims

1. Semiconductor die (1), in particular for a MEMS-sensor device (3), the semiconductor die (1) having a top side (15), a bottom side (17) opposite to the top side (15), and at least one side surface (19) connecting the top side (15) and the bottom side (17), wherein the bottom side (17) and at least parts of the at least one side surface (17) are configured to be attached to a solid structure (5) via a die attach material (7), **characterized in that** at least the side surface (19) comprises at least one attachment control element (37) that is configured to define at least one attachment zone (39) of the side surface (19) to be contacted by the die attach material (7) and/or at least one exclusion zone (45) configured to not to be contacted by the die attach material (7).

2. Semiconductor die (1) according to claim 1, **characterized in that** the at least one attachment control element (37) is a stop element (41) for defining a maximum height (40) for the die attach material (7).

3. Semiconductor die (1) according to claim 2, **characterized in that** the stop element (41) forms a physical barrier (43) between the at least one attachment zone (39) and the at least one exclusion zone (45).

4. Semiconductor die (1) according to claim 2 or 3, **characterized in that** the stop element (41) is formed as a step (47) between two vertical sections (49, 51) of the side surface (19).

5. Semiconductor die (1) according to any one of claims 1 to 4, **characterized in that** the at least one attachment control element (37) is formed as at least one region (65, 69) with an increased or decreased wettability for the die attach material (7) compared to a surface (19, 59) of the semiconductor die (1) in an adjacent region (67).

6. Semiconductor die (1) according to claim 5, **characterized in that** the at least one attachment control element (37) is formed as a functionalized surface (66) in the at least one region (65, 69).

7. Semiconductor die (1) according to any one of claims 1 to 6, **characterized in that** the bottom side (17) of the semiconductor die (1) comprises a functionalized surface (66) at least in sections.

8. Semiconductor die (1) according to any one of claims 1 to 7, **characterized in that** the bottom side (17) of the semiconductor die (1) is provided with at least one spacer (71) for spacing a bottom surface (59) of the semiconductor die (1) apart from the solid structure (5).

9. Semiconductor die (1) according to any one of claims 1 to 8, **characterized in that** the semiconductor die (1) comprises at least one membrane (11).

10. Semiconductor die (1) according to any one of claims 1 to 9, **characterized in that** the semiconductor die (1) has an overall Π-shaped cross section comprising two legs (23) and a web (25) connecting the legs (23) at a right angle, wherein the top side (15) forms the web (17) and wherein outer sides (21) of the legs (23) form side surfaces (19).

11. Method for attaching a semiconductor die (1) to a solid structure (5), the method comprising the steps of:
- providing a wafer made from at least one semiconducting material;
- forming at least one attachment control element (37) for at least one semiconductor die (1);
- separating the wafer into separate semiconductor dies (1);
- attaching at least one of the semiconductor dies (1) comprising at least one attachment control element (37) to a solid structure (5) using a die attach material (7).

12. Method according to claim 11, **characterized in that** the at least one attachment control element (37) is formed by at least one of the following method: laser cutting, sawing, etching.

13. Method according to claim 11 or 12, **characterized in that** the surface (59) of a bottom side (17) or at least one side surface (19) of at least one semiconductor die (1) to be separated from the wafer is functionalized by using at least one of the following methods: coating, etching, layer deposition.

14. Method according to any one of claims 11 to 13, **characterized in that** the same method is used for separating the wafer into the semiconductor dies (1) and for forming the at least one attachment control element (37).

15. MEMS-sensor device (3), the device comprising at least one semiconductor die (1) according to any one of claims 1 to 10 and/or at least one semiconductor die (1) produced using a method according to any one of claims 11 to 14, wherein the semiconductor die (1) further comprises at least one membrane (11) containing piezoresistive elements and is attached to a solid structure (5) by a die attach material (7), the die attach material (7) extending at least in regions between the semiconductor die (1) and the solid structure (5).
